# EUROPEAN PATENT APPLICATION

(11) **EP 2 086 097 A2**
(43) Date of publication of application: **05.08.2009**
(21) Application number: 07024472.8
(22) Date of filing: 18.12.2007
(51) Int. Cl.: H02M 3/155

(54) **Printed circuit board and liquid crystal display having the same**

(30) Priority: 05.01.2007 KR 20070001608
(71) Applicant: Samsung Electronics Co., Ltd., Yeongtong-gu Suwon-city, Gyeonggi-do 442-742 (KR)
(72) Inventor: Hong, Hyun-seok, Seo-gu Daejeon (KR); Jeon, Myoung-ha, Chungcheongnam-do (KR); Lee, Geun-ho, Nowon-gu Seoul (KR)
(74) Representative: Dr. Weitzel & Partner

(57) **Abstract**

A printed circuit board for a liquid crystal display that has a structure for preventing interference between a feedback voltage generating unit or a compensating unit of a DC-DC converter and a pulse signal wiring line. The printed circuit board has a boosting circuit for boosting an input voltage to generate an analog driving voltage and a pulse signal, the boosting circuit including a control chip and an inductor coupled between an input voltage node and the control chip, the control chip supplied with a feedback voltage for controlling the amount of current flowing through the inductor, a feedback voltage generating circuit for supplying the feedback voltage to the control chip by using the analog driving voltage, and a pulse signal wiring line connecting the control chip and the inductor, and separated from the feedback voltage generating circuit.

## Description

### BACKGROUND OF THE INVENTION

### Field of the Invention

The present invention relates to a liquid crystal display having a printed circuit board that prevents interference between a DC-DC converter and the pulse signal wiring.

### Description of the Related Art

Liquid crystal displays (LCDs) are now widely used as flat panel . A liquid crystal display includes two substrates having electrodes formed thereon and a liquid crystal layer interposed between the substrates. In the liquid crystal display, a voltage is applied to the electrodes so as to rearrange liquid crystal molecules in the liquid crystal layer, thereby controlling the amount of light passing through the liquid crystal layer. In this way, the liquid crystal display displays an image.

The liquid crystal display includes a common electrode substrate that is composed of a common electrode and a thin film transistor substrate that is composed of a thin film transistor array. The common electrode substrate and the thin film transistor substrate are disposed facing each other. A liquid crystal layer is interposed between the two display panels. In the liquid crystal display, when a voltage is applied between the two display panels, liquid crystal molecules of the liquid crystal layer are rearranged, thereby controlling the transmittance of light. In this way, the liquid crystal display displays an image. However, since the liquid crystal display does not emit light, a backlight unit that supplies light is disposed below the thin film transistor substrate.

Further, a printed circuit board that includes various driving circuits for driving a liquid crystal panel is included in the liquid crystal display. A large number of parts and wiring lines that form the driving circuits need to be disposed on the printed circuit board. Therefore, in order to efficiently dispose the parts and the wiring lines within a limited space, a printed circuit board having a multi-layered structure is used.

With the use of the printed circuit board having the multi-layered structure, a large number of parts and wiring lines can be disposed within the limited space. However, as the distances between parts and parts, parts and wiring lines, wiring lines and wiring lines become relatively closer to each other, the parts and the wiring lines electrically affect each other. That is, electrical interference occurs. Since the electrical interference affects the operation of the individual parts, electrical noise may occur during output or the like or signal distortion may occur. Therefore, normal operation of the liquid crystal display may be obstructed.

### SUMMARY OF THE INVENTION

According to one aspect of the present invention, a printed circuit board prevents interference between a DC-DC converter and a pulse signal wiring line. The printed circuit board includes a boosting circuit for boosting an input voltage to generate an analog driving voltage and a pulse signal, the boosting circuit including a control chip and an inductor that is coupled between an input voltage node and the control chip, the control chip supplied with a feedback voltage and controlling the amount of current flowing through the inductor, a feedback voltage generating circuit for supplying the feedback voltage to the control chip by using the analog driving voltage, and a pulse signal wiring line connecting the control chip and the inductor, outputting the pulse signal, the pulse signal wiring line being separated from the feedback voltage generating circuit.

According to a second aspect of the present invention, a printed circuit board having a boosting circuit forming region, a feedback voltage generating circuit forming region, and a compensating circuit forming region defined thereon, a boosting circuit formed on the boosting circuit forming region and boosting an input voltage so as to generate an analog driving voltage and a pulse signal, the boosting circuit including a control chip and an inductor coupled between an input voltage node to which the input voltage is applied and the control chip, the control chip supplied with a feedback voltage and controlling the amount of current flowing through the inductor, a feedback voltage generating circuit supplying the feedback voltage to the control chip by using the analog driving voltage, a compensating circuit for stabilizing the output of the analog driving voltage, and a pulse signal wiring line connecting the control chip and the inductor and separated from the feedback voltage generating circuit.

According to a third aspect of the present invention, there is provided a liquid crystal display, the liquid crystal display including the above-described printed circuit board.

### BRIEF DESCRIPTION OF THE DRAWINGS

The above and other features and advantages of the present invention will become more apparent by describing in detail preferred embodiments thereof with reference to the attached drawings. in which:

FIG. 1 is a block diagram of a liquid crystal display according to a first embodiment of the present invention;

FIG. 2 is a circuit diagram of a DC-DC converter that is included in the liquid crystal display of FIG. 1;

FIG. 3 is a layout view of a printed circuit board according to the first embodiment of the present invention;

FIG. 4 is an exploded perspective view illustrating a multi-layered structure of the printed circuit board of FIG. 3;

FIG. 5 is an enlarged view of the printed circuit board of FIG. 3;

FIG. 6 is a layout view of a printed circuit board according to a second embodiment of the present invention; and

FIG. 7 is a layout view of a printed circuit board according to a third embodiment of the present invention.

### DESCRIPTION OF THE PREFERRED EMBODIMENTS

It will be understood that when an element or a layer is referred to as being "on" another element or layer, it can be directly on the other element or intervening elements may also be present. In contrast, when an element is referred to as being "directly on" another element, there are no intervening elements present.

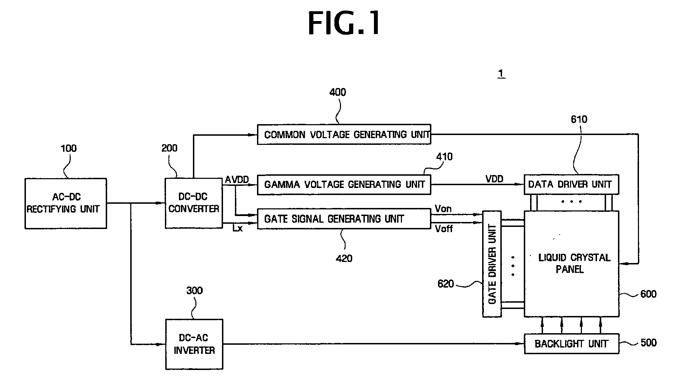

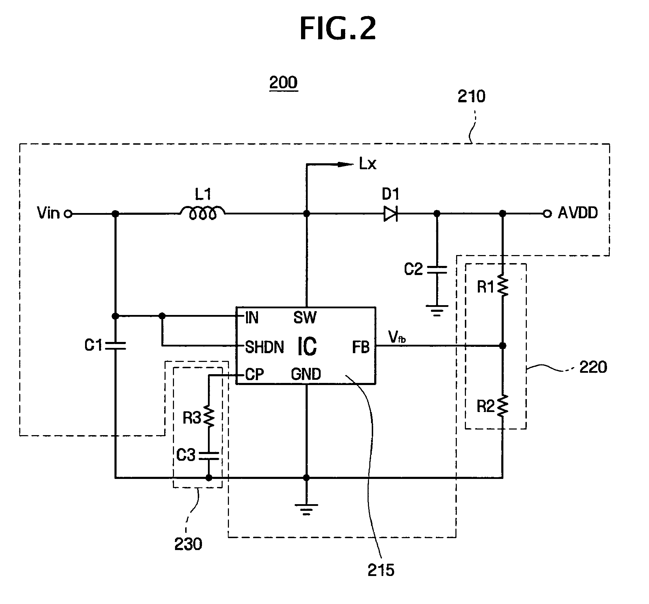

A liquid crystal display according to a first embodiment of the present invention will be described in detail with reference to FIGS. 1 and 2. FIG. 1 is a block diagram of a liquid crystal display according to a first embodiment of the present invention. FIG. 2 is a circuit diagram of a DC-DC converter that is included in the liquid crystal display of FIG. 1.

A liquid crystal display 1 according to the first embodiment of the present invention displays predetermined image information, which is supplied by an external graphic controller (not shown), through a liquid crystal panel 600. The liquid crystal display 1 includes an AC-DC rectifying unit 100, a DC-AC inverter 300, a DC-DC converter 200, a common voltage generating unit 400, a gamma voltage generating unit 410, a gate signal generating unit 420, the liquid crystal panel 600, a data driver unit 610, a gate driver unit 620, and a backlight unit 500.

The AC-DC rectifying unit 100 is typically supplied with an AC voltage in a range of 1 00 to 240 V, converts the applied AC voltage into a high DC voltage in a range of 500 to 600 V, and supplies the converted DC voltage to the DC-AC inverter 300 and the DC-DC converter 200. The AC-DC rectifying unit 100 includes power factor correction (PFC), and is realized as a diode rectifier, an active PWM (Pulse Width Modulation) rectifier, or the like.

The DC-AC inverter 300 supplies a driving voltage for driving lamps (not shown). The DC-AC inverter 300 changes the high DC voltage generated in the AC-DC rectifying unit 100 into a voltage having a voltage level appropriate for driving the lamps (not shown), and outputs the changed voltage.

The DC-AC inverter 300 does not only change the level of voltage but also changes the high DC voltage generated in the AC-DC rectifying unit 100 into an AC voltage appropriate for the backlight unit and outputs the AC voltage. Examples of the DC-AC inverter 300 may include a "Royer" inverter, a push-pull inverter, a half-bridge inverter, a full-bridge inverter, or the like.

The DC-DC converter 200 converts the level of the high DC voltage generated in the AC-DC rectifying unit 100 so as to generate a pulse signal Lx or an analog driving voltage AVDD, and transmits the generated pulse signal Lx or analog driving voltage AVDD to the common voltage generating unit 400, the gamma voltage generating unit 410, and the gate signal generating unit 420. The common voltage generating unit 400, the gamma voltage generating unit 410, and the gate signal generating unit 420 generate a common voltage Vcom, a gamma voltage VDD, and gate on/off signals Von and Voff, respectively, by using the pulse signal Lx or the analog driving voltage AVDD.

Specifically, referring to FIG. 2, the DC-DC converter 200 includes a boosting circuit 210, a feedback voltage generating circuit 220, and a compensating circuit 230. The boosting circuit 210 includes a control chip 215, which is an integrated circuit (IC) including an input terminal IN, a control terminal SHDN, a switch terminal SW, a feedback terminal FB, and a ground terminal GND, an inductor L1 , a diode D1, an input capacitor C1, and an output capacitor C2.

When a predetermined input power supply voltage Vin is applied to input terminal IN, the control terminal SHDN generates a control signal for controlling the operation of the DC-DC converter 200.

Further, the switch terminal SW is connected to a switching element (not shown), which is disposed on the inside or outside, and controls the operation of the boosting circuit 210. Also, the switch terminal SW converts a voltage level of the input power supply voltage Vin into the pulse signal Lx. The switch terminal SW performs a switching operation according to a switch control signal that is input from the outside. The switch terminal SW may include an NMOS transistor A drain terminal of the NMOS transistor is connected to the feedback voltage generating circuit 220, a source terminal thereof is connected to a ground terminal, and a gate terminal thereof is connected so that the switch terminal SW receives the switch control signal. According to the above-described operation of the switch terminal SW, the input power supply voltage Vin is boosted to thereby generate the pulse signal Lx. The pulse signal Lx is transformed into the analog driving voltage AVDD by the diode D1 and the output capacitor C2. Here, the pulse signal Lx refers to a switching waveform that becomes a source signal of the analog driving voltage AVDD, that is, an orthogonal waveform having a predetermined level. The pulse signal Lx is also used as a pulse signal for a charge pumping circuit inside the gate signal generating unit 420.

The feedback terminal FB is supplied with a feedback voltage Vfb that is applied from the feedback voltage generating circuit 220, and transmits the feedback voltage Vfb to the switch terminal SW. The feedback voltage Vfb is generated when the analog driving voltage AVDD is divided by the feedback voltage generating circuit 220.

As described above, the input terminal IN, the control terminal SHDN, the switch terminal SW, the feedback terminal FB, and the ground terminal GND may form an integrated circuit IC, that is, all of the above-described terminals function in one chip. Alternatively, each of the terminals may form a separate circuit that performs the described function .

Inductor L1 included in the boosting circuit 210 includes an input voltage node, to which the input voltage Vin is applied, and stores an input charge. The other terminal of the inductor L1 is coupled to terminal SW of control chip 215 which generates the pulse signal Lx. The generated pulse signal Lx is rectified by the diode D1 which outputs analog driving voltage AVDD. Input capacitor C1 and the output capacitor C2 stabilize the input power supply voltage Vin and the analog driving voltage AVDD.

Feedback voltage generating circuit 220 generates the feedback voltage Vfb for generating the analog driving voltage AVDD according to the switch control signal that is supplied from the outside, and outputs the generated feedback voltage Vfb to the feedback terminal FB of the control chip 215. The feedback voltage generating circuit 220 may be composed of first and second voltage dividing resistors R1 and R2.

The first and second voltage dividing resistors R1 and R2 divide the analog driving voltage AVDD at a predetermined ratio to thereby generate the feedback voltage Vfb. Feedback voltage generating circuit 220 can include at least one selection resistor for more finely controlling the voltage in addition to the first and second voltage dividing resistors R1 and R2, if necessary. The feedback voltage generating circuit 220 may also include a capacitor for increasing the stability of the analog driving voltage AVDD.

The compensating circuit 230 controls variation in the output resulting from a change in load on the analog driving voltage AVDD. The compensating circuit 230 includes a resistor R3 and a capacitor C3.

Referring to FIG. 1 again, the common voltage generating unit 400 generates a common voltage Vcom by using the DC voltage whose level has been changed by the DC-DC converter 200, and supplies the generated common voltage Vcom to the liquid crystal panel 600.

The gamma voltage generating unit 410 is applied with the analog driving voltage AVDD from the DC-DC converter 200, generates a gamma voltage VDD, and supplies the gamma voltage VDD to the data driver unit 610.

The data driver unit 610 performs gamma compensation on image signals for performing display by using the gamma voltage VDD that is supplied from the gamma voltage generating unit 410, and outputs the image signals having been subjected to the gamma compensation to the liquid crystal panel 600.

The gate signal generating unit 420 is supplied with the analog driving voltage AVDD and the pulse signal Lx from the DC-DC converter 200, and generates gate on/off signals Von and Voff for operating a gate.

The gate driver unit 620 applies the gate on/off signals Von and Voff to gate lines of the liquid crystal panel 600 to thereby operate switching elements that are connected to the gate lines.

The liquid crystal panel 600 is applied with electrical signals from the data driver unit 610 and the gate driver unit 620, respectively, and displays an image on a screen. The liquid crystal panel 600 includes a common electrode substrate and a thin film transistor substrate that face each other with a predetermined interval therebetween and are attached to each other, and a liquid crystal layer that has therein liquid crystal molecules aligned in a predetermined direction at a space formed between the two display panels.

Further, the liquid crystal panel 600 is connected to the data driver unit 610 and the gate driver unit 620 through data lines and the gate lines, respectively. The backlight unit 500 that supplies light is disposed below the liquid crystal panel 600.

The backlight unit 500 supplies light to the liquid crystal panel 600 that is formed of a non-light emitting element. The backlight unit 500 irradiates light from a rear surface of the liquid crystal panel 600. The backlight unit 500 includes fluorescent lamps (not shown). The fluorescent lamps (not shown) may be direct type lamps, edge type lamps, or the like according to the shape of the liquid crystal display 1, that is, various arrangement of the fluorescent lamps (not shown) is possible. The fluorescent lamps (not shown) are applied with a high AC voltage that is supplied by the DC-AC inverter 300, and emits light.

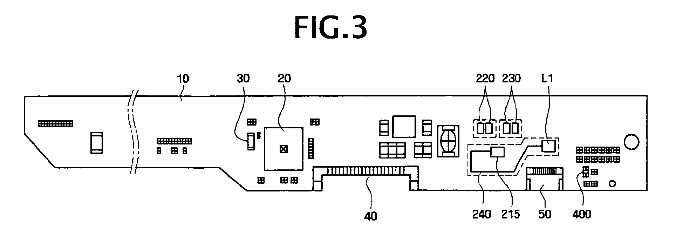

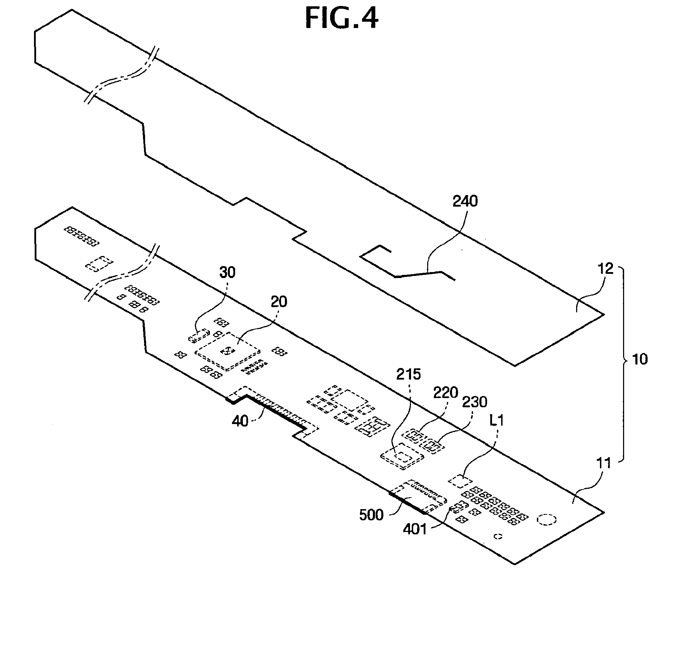

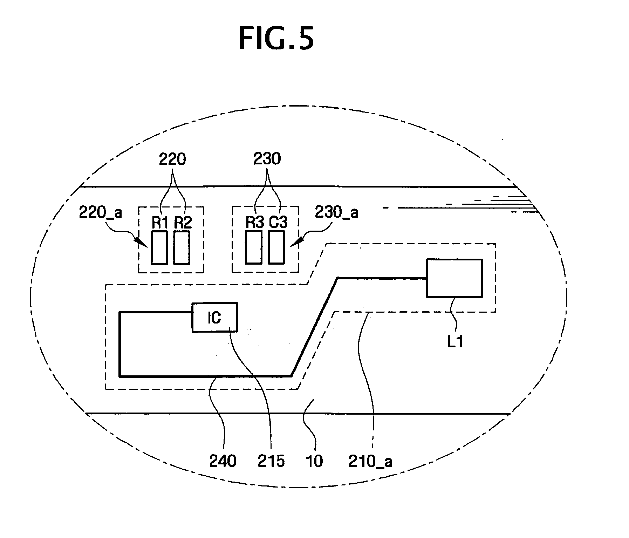

A printed circuit board according to the first embodiment of the present invention will be described in detail with reference to FIGS. 3 to 5. FIG. 3 is a layout view of a printed circuit board according to the first embodiment of the present invention. FIG. 4 is an exploded perspective view illustrating a multi-layered structure of the printed circuit of FIG. 3. FIG. 5 is an enlarged view of the printed circuit board of FIG. 3.

The printed circuit board 10 according to the first embodiment of the present invention includes a timing controller 20, a memory chip 30, the DC-DC converter 200, an input power connector 40, a test signal connector 50, a common voltage generating circuit 401, and the like. Since the printed circuit board 10 has a multi-layered structure, a board on which various parts are mounted and a board in which wiring lines are printed may be formed on two different layers from each other. For example, as shown in FIG. 4, various parts may be formed on a first board 11 and wiring lines connecting the individual parts may be printed in a second board 12. There may be two circuit boards, each having the above-described multi-layered structure, if necessary. Various modifications of the arrangement of the parts and the wiring lines between the layers are possible, if necessary.

The timing controller 20 receives an image signal and an input control signal, which controls the image signal, from an external graphic controller (not shown), and generates a gate control signal, data control signal, and the like. Further, the timing controller 20 transmits the gate control signal to the gate driver unit 620, and the data control signal and the image signal to the data driver unit 610.

The memory chip 30 stores a variety of data information for the operation of the timing controller 20. For example, various conditions for generating the data control signal and the gate control signal may be stored in the memory chip 30. The memory chip 30 may be, for example, an EEPROM (Electrically Erasable and Programmable Read Only Memory).

Further, the input power connector 40 to which input power is supplied, the test signal connector 50 to which a test signal is input, and other various parts for driving the liquid crystal panel 600 are mounted on the printed circuit board 10.

Referring to FIG. 5, the arrangement relationship of the boosting circuit 210, the feedback voltage generating circuit 220, the compensating circuit 230, a pulse signal wiring line 240, and the inductor L1 will be described.

The inductor L1, the diode D1, the input and output capacitors C1 and C2, and the control chip 215, which form the boosting circuit 210, are disposed on a boosting circuit forming region 210 _a that is defined on the printed circuit board 10.

The first and second voltage dividing resistors R1 and R2 that form the feedback voltage generating circuit 220 are disposed on a feedback voltage generating circuit forming region 220_a that is defined on the printed circuit board 10.

Further, the resistor R3 and the capacitor C3 that form the compensating circuit 230 are also disposed on a compensating circuit forming region 230_a that is defined on the printed circuit board 10.

It is preferable that the boosting circuit 210, the feedback voltage generating circuit 220, and the compensating circuit 230 that form the DC-DC converter 200 and thus are closely related to each other be disposed adjacent to each other so as not to generate a signal delay between the individual parts. The individual parts need to be disposed so as not to generate interference between the adjacent parts because a space of the printed circuit board 10 is limited.

The boosting circuit forming region 210_a, the feedback voltage generating circuit forming region 220_a, and the compensating circuit forming region 230_a can be variously arranged according to the use of the space of the printed circuit board 10. As shown in FIG. 5, the boosting circuit forming region 210_a may be widened and thus distances between the individual parts may become large. That is, as the control chip 215 and the inductor L1 are separated from each other, the control chip 215 and the inductor L1 are connected through the pulse signal wiring line 240. When the pulse signal wiring line 240 becomes too long, a signal delay may occur. Therefore, the arrangement needs to take into account the length of the wiring line.

In the printed circuit board 10 according to the first embodiment of the present invention, the feedback voltage generating circuit 220 and the compensating circuit 230 are separated from the pulse signal wiring line 240 so as not to overlap each other. The pulse signal wiring line 240 may be disposed on the board in a different layer from the layer of the feedback voltage generating circuit 220 or the compensating circuit 230. However, when the pulse signal wiring line 240 and the feedback voltage generating circuit 220 or the compensating circuit 230 overlap each other, or are separated but disposed adjacently to each other, interference occurs therebetween. As a result, the output signal of the analog driving voltage AVDD may not be output in a normal state. When the analog driving voltage AVDD is not output in a normal state, a normal signal is not input to the liquid crystal panel 600, and thus an image being displayed is distorted or a normal screen may not be viewed.

To prevent the pulse signal wiring line 240 and the feedback voltage generating circuit 220 or the compensating circuit 230 from interfering with each other, they need to be disposed with a predetermined interval therebetween that is determined taking into account the size of the printed circuit board 10, the number of parts mounted, position, and the like. However, it is preferable that the pulse signal wiring line 240 and the feedback voltage generating circuit 220 or the compensating circuit 230 be separated from each other with an interval of 5 mm or more, and preferably, 10 mm or more.

As such, in order that the pulse signal wiring line 240 and the feedback voltage generating circuit 220 or the compensating circuit 230 are disposed separated from each other, the pulse signal wiring line 240 is disposed without passing between the control chip 215 and the feedback voltage generating circuit 220 or the compensating circuit 230. In order that the control chip 215 be located between the pulse signal wiring line 240 and the feedback voltage generating circuit 220 or the compensating circuit 230, the pulse signal wiring line 240 detours away from the control chip 215. Therefore, the pulse signal wiring line 240 starts from a side surface of the control chip 215 and is connected to the inductor L1 toward an opposite side where the feedback voltage generating circuit 220 or the compensating circuit 230 is not located.

The pulse signal wiring line 240 that connects the control chip 215 and the inductor L1 may be connected to a gate signal generating circuit (not shown) generating gate on/off signals, and supply a pulse signal Lx. Therefore, the pulse signal wiring line 240 does not only refer to a wiring line that connects the control chip 21 5 and the inductor L1, but also refers to all kinds of wiring lines that are connected to the control chip 215 and the inductor L1 and applied with the pulse signal Lx.

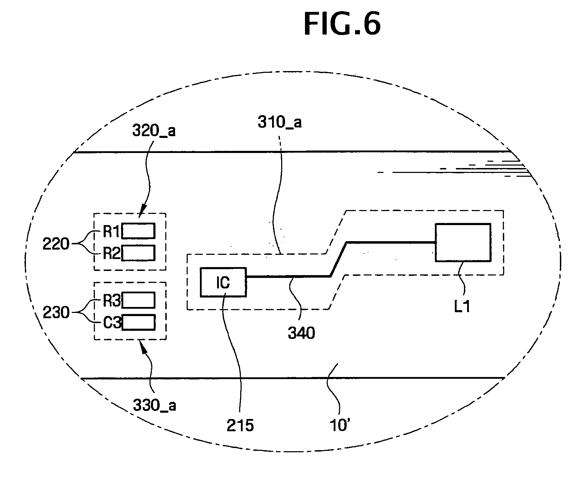

Hereinafter, the arrangement relationship of a printed circuit board according to a second embodiment of the present invention will be described with reference to FIG. 6. FIG. 6 is a layout view of a printed circuit board according to a second embodiment of the present invention. For the convenience of explanation, members having the same functions as the members shown in the drawings of the first embodiment are referred to as the same reference numbers, and thus descriptions thereof will be omitted.

In a printed circuit board 10' according to the second embodiment of the present invention, a control chip 21 5 is disposed between an inductor L1 and a feedback voltage generating circuit 220 and a compensating circuit 230.

That is, a boosting circuit forming area 310_a, a feedback voltage generating circuit forming region 320_a, and a compensating circuit forming region 330_a are defined on the printed circuit board 10'. A boosting circuit 210, a feedback voltage generating circuit 220, and a compensating circuit 230 are disposed on the above-described three regions, respectively.

Specifically, the control chip 215 is disposed between the inductor L1 and the feedback voltage generating circuit 220 and the compensating circuit 230. A starting point of a pulse signal wiring line 340 that is diverged from the control chip 215 is disposed along a direction in which the inductor L1 is located. As such, the feedback voltage generating circuit 220, the compensating circuit 230, the control chip 215, and inductor L1 are sequentially disposed, and the pulse signal wiring line 340 is diverged from a direction in which the feedback voltage generating circuit 220 and the compensating circuit 230 face the inductor L1, that is, an opposite side to the feedback voltage generating circuit 220 and the compensating circuit 230. In this way, it is possible to dispose the feedback voltage generating circuit 220 or the compensating circuit 230 and the pulse signal wiring line 340 such that the feedback voltage generating circuit 220 or the compensating circuit 230 and the pulse signal wiring line 340 are separated from each other at a predetermined distance therebetween so as not to overlap each other.

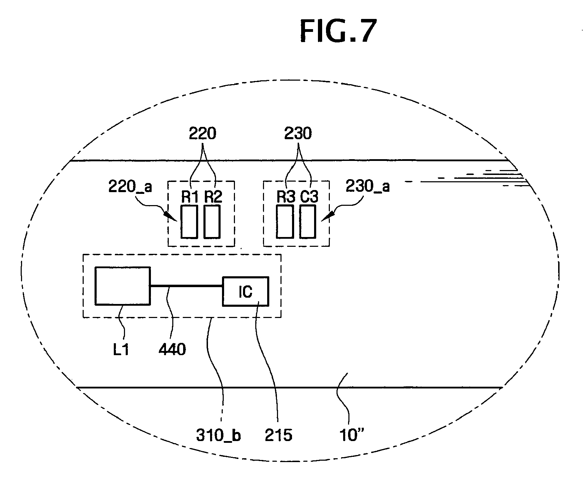

Hereinafter, the arrangement relationship of a printed circuit board according to a third embodiment of the present invention will be described with reference to FIG. 7. FIG. 7 is a layout view of a printed circuit board according to a third embodiment of the present invention. For the convenience of explanation, members having the same functions as the members shown in the drawings of the first embodiment are referred to as the same reference numbers, and thus descriptions thereof will be omitted.

In a printed circuit board 10" according to a third embodiment of the present invention, a control chip 215 and an inductor L1 are disposed adjacent to each other. That is, a boosting circuit forming region 310_b, a feedback voltage generating circuit forming region 220_a, and a compensating circuit forming region 230_a are formed on the printed circuit board 10". A boosting circuit 210, a feedback voltage generating circuit 220, and a compensating circuit 230 are disposed on the above-described three regions, respectively.

Specifically, when the control chip 215 and the inductor L1 are disposed adjacent to each other and a distance between the two elements decreases, the length of a pulse signal wiring line 440 is reduced. Therefore, when the pulse signal wiring line 440 is disposed, it is possible to prevent the pulse signal wiring line 440 from being disposed adjacent to the feedback voltage generating circuit 220 or the compensating circuit 230. Accordingly, interference of the pulse signal wiring line 440 can be reduced.

As such, even when a gate signal generating unit 420 is disposed adjacent to the control chip 21 5, it is preferable that the control chip 21 5 be disposed between the pulse signal wiring line 440 and the gate signal generating unit 420 ,and the feedback voltage generating circuit 220 or the compensating circuit 230 and the pulse signal wiring line 440 be disposed facing each other.

Although the present invention has been described in connection with the exemplary embodiments of the present invention, it will be apparent to those skilled in the art that various modifications and changes may be made thereto without departing from the scope and spirit of the invention. Therefore, it should be understood that the above embodiments are not limitative, but illustrative in all aspects.

As described, according to the printed circuit boards according to the embodiments of the present invention and the liquid crystal display having the same, since interference between the feedback voltage generating circuit or the compensating circuit of the DC-DC converter and the pulse signal wiring line can be prevented, it is possible to prevent an image displayed on the liquid crystal panel from being distorted due to the interference therebetween or residual images from occurring.

## Claims

1. A printed circuit board comprising:
a board having a boosting circuit and a feedback voltage generating circuit defined thereon;
the boosting circuit boosting an input voltage so as to generate an analog driving voltage and a pulse signal, the boosting circuit including a control chip and an inductor that is coupled between an input voltage node and the control chip, the control chip supplied with a feedback voltage and controlling the amount of current flowing through the inductor from the input voltage;
a feedback voltage generating circuit for supplying the feedback voltage to the control chip using the analog driving voltage; and
a pulse signal wiring line connecting the control chip and the inductor, outputting a pulse signal, the pulse signal wiring line being separated from the feedback voltage generating circuit.

2. The printed circuit board of claim 1, wherein:
the board has a multi-layered structure, and
the feedback voltage generating circuit and the pulse signal wiring line are disposed on different layers from each other.

3. The printed circuit board of claim 2, wherein the feedback voltage generating circuit and the pulse signal wiring line are disposed so as not to overlap each other.

4. The printed circuit board of claim 1, wherein the pulse signal wiring line is disposed so as not to be located between the feedback voltage generating circuit and the control chip.

5. The printed circuit board of claim 4, wherein the control chip is disposed between the feedback voltage generating circuit and the pulse signal wiring line.

6. The printed circuit board of claim 4, wherein the control chip is disposed between the feedback voltage generating circuit and the inductor.

7. The printed circuit board of claim 1, wherein the feedback voltage generating circuit and the pulse signal wiring line are disposed separated from each other with an interval of 5 mm or more.

8. The printed circuit board of claim 1, further comprising:
a compensating circuit formed on the board and stabilizing output of the
analog driving voltage,
wherein the compensating circuit and the pulse signal wiring line are disposed separated from each other.

9. The printed circuit board of claim 8, wherein the compensating circuit and the pulse signal wiring line are disposed so as not to overlap each other.

10. The printed circuit board of claim 8, wherein the pulse signal wiring line is disposed so as not to be located between the compensating circuit and the control chip.

11. The printed circuit board of claim 10, wherein the control chip is disposed between the compensating circuit and the pulse signal wiring line.

12. The printed circuit board of claim 10, wherein the control chip is disposed between the compensating circuit and the inductor.

13. The printed circuit board of claim 8, wherein the compensating circuit and the pulse signal wiring line are disposed separated from each other with an interval of 5 mm or more.

14. The printed circuit board of claim 1, wherein the feedback voltage generating circuit comprises first and second voltage dividing resistors that divide the analog driving voltage and generate a feedback voltage.

15. The printed circuit board of claim 1, wherein the pulse signal wiring line is connected to a gate signal generating circuit that generates gate on/off signals.

16. A liquid crystal display comprising:
a liquid crystal panel including a common electrode substrate and a thin film transistor substrate that face each other with a predetermined interval there between, a liquid crystal layer interposed between the common electrode substrate and the thin film transistor substrate;
a printed circuit board for applying a driving signal to the liquid crystal panel including, a board having a boosting circuit forming region, a feedback
voltage generating circuit forming region, and a compensating circuit forming region defined thereon,
a boosting circuit formed on the boosting circuit forming region and boosting an input voltage so as to generate an analog driving voltage and a pulse signal, the boosting circuit including a control chip and an inductor that is coupled between an input voltage node to which the input voltage is applied and the control chip, the control chip supplied with a feedback voltage and controlling the amount of current flowing through the inductor from the input voltage,
a feedback voltage generating circuit formed on the feedback voltage generating circuit forming region and supplying the feedback voltage to the control chip by using the analog driving voltage,
a compensating circuit formed on the compensating circuit forming region and stabilizing output of the analog driving voltage; and
a pulse signal wiring line connecting the control chip and the inductor, and disposed at a distance from the feedback voltage generating circuit.

17. The liquid crystal dispaly of claim 16, wherein:
the board has a multi-layered structure, and
the compensating circuit and the pulse signal wiring line are disposed on different layers from each other.

18. The liquid crystal dispaly of claim 17, wherein the compensating circuit and the pulse signal wiring line are disposed so as not to overlap each other.

19. The liquid crystal dispaly of claim 16, wherein the pulse signal wiring line is disposed so as not to be located between the compensating circuit and the control chip.

20. The liquid crystal dispaly of claim 16, wherein the compensating circuit and the pulse signal wiring line are disposed separated from each other with an interval of 5 mm or more.
